# EUROPÄISCHE PATENTSCHRIFT

(11) **EP 0 949 753 B1**
(45) Veröffentlichungstag und Bekanntmachung des Hinweises auf die Patenterteilung: **27.09.2006**
(21) Anmeldenummer: 99106938.6
(22) Anmeldetag: 03.04.1999
(51) Int. Cl.: H03F 1/52, H03G 3/30

(54) **Steuereinrichtung für einen Audioverstärker**
Control system for an audio amplifier
Système de commande pour un amplificateur audio

(30) Priorität: 09.04.1998 DE 19815923
(43) Veröffentlichungstag der Anmeldung: 13.10.1999
(73) Patentinhaber: Grundig Multimedia B.V., 1083HJ Amsterdam (NL)
(72) Erfinder: Bauer, Jörg, c/o Grundig AG, 90762 Fürth (DE)
(74) Vertreter: Pröll, Jürgen

(56) Entgegenhaltungen:
- EP-A- 0 292 105
- EP-A- 0 399 276
- EP-A- 0 537 792
- US-A- 4 198 603
- US-A- 4 380 824
- US-A- 4 939 786

## Beschreibung

Die vorliegende Erfindung betrifft eine Steuereinrichtung für einen Audioverstärker, insbesondere eine Steuereinrichtung zur Verringerung störender Beeinflussungen wiederzugebender Audiosignale.

Beim Betrieb von Audioverstärkern, insbesondere in Kraftfahrzeugen, tritt eine Reihe von störenden Beeinflussungen auf, die sich bei der Wiedergabe von Audiosignalen mittels des Audioverstärkers unangenehm bemerkbar machen können.

Ein bekanntes Problem sind Störgeräusche, wie sie z. B. von Lichtmaschine oder Zündung verursacht werden können und den Empfang von Rundfunksignalen beeinflussen. Bei sich verschlechterndem Empfang machen sich derartige Störgeräusche immer stärker bemerkbar und können sogar lauter als die ursprüngliche Nutzmodulation werden. Dieses Problem macht sich vor allem bei amplitudenmodulierten Rundfunksignalen bemerkbar.

Ein weiteres Problem stellt die thermische Belastung heutiger Audioverstärker dar. Bei ständig steigender Ausgangsleistung der Endstufen der Audioverstärker ist die thermische Stabilität wegen der gleichzeitigen Kostenreduzierung, die z. B. zu kleineren Kühlkörpern geführt hat, in zunehmendem Maße schwieriger sicherzustellen. Bei bekannten Audioverstärkern ist deshalb bei Erreichen einer vorgegebenen Temperatur die vollständige Abschaltung des Audioverstärkers vorgesehen. Nach ausreichender Abkühlung wird der Audioverstärker wieder in Betrieb genommen. Eine derartige Vorgehensweise ist aber besonders nachteilig, da bei Benutzern derartig arbeitender Audioverstärker der Eindruck entstehen kann, daß der Audioverstärker defekt ist.

Aus US-A-4,198,603 ist ein Autoradiogerät mit einer Signaldämpfung offenbart. Das Autoradiogerät weißt ein AGC-Signal auf, welches sich aus einer Rauschüberwachung ergibt. In Abhängigkeit des Ergebnisses und der Einstellung eines Benutzers für die Rauschschwelle wird die Lautstärke entsprechend linear angepasst.

Es ist daher Aufgabe der vorliegenden Erfindung, eine Steuervorrichtung für einen Audioverstärker anzugeben, bei der bei der Verringerung störender Beeinflussungen des wiederzugebenden Audiosignals die aus dem Stand der Technik bekannten Nachteile und Probleme vermieden werden.

Bei der erfindungsgemäßen Steuervorrichtung für einen Audioverstärker, insbesondere eine Steuereinrichtung zur Verringerung störender Beeinflussungen wiederzugebender Audiosignale, wird diese Aufgabe dadurch gelöst, daß die Steuereinrichtung beim Auftreten von störenden Beeinflussungen der wiederzugebenden Audiosignale die Leistung des Audioverstärkers verringert, um die Wiedergabelautstärke der Audiosignale zu reduzieren, und daß die Steuereinrichtung nach Ausbleiben der störenden Beeinflussungen der wiederzugebenden Audiosignale die Leistung des Audioverstärkers auf den vor der Verringerung eingestellten Wert erhöht

Die Erfindung geht dabei von der Überlegung aus, daß durch die Verringerung der Verstärkungsleistung des Audioverstärkers - und damit der Lautstärke der wiederzugebenden Audiosignale -, bei Vorliegen von störenden Beeinflussungen des wiederzugebenden Audiosignals, die Wirkung der störenden Beeinflussungen verringert wird. Insbesondere wird durch die Verringerung die aus dem Stand der Technik bekannte, besonders nachteilige völlige Abschaltung des Audioverstärkers vermieden.

Weitere Vorteile der vorliegenden Erfindung ergeben sich aus den abhängigen Ansprüchen sowie der nachfolgenden Beschreibung des erfindungsgemäßen Audioverstärkers anhand eines Ausführungsbeispiels mittels einer Figur.

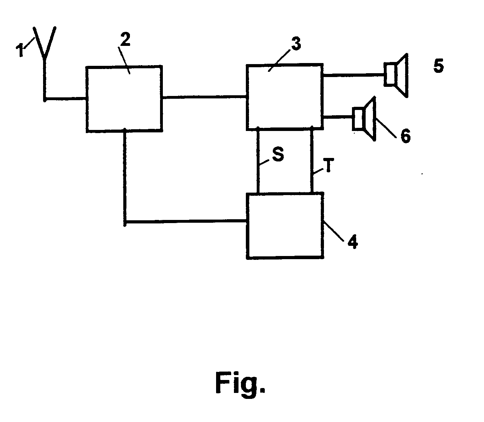

Die einzige Figur zeigt ein Prinzipschaltbild eines Ausführungsbeispiels einer erfindungsgemäßen Steuereinrichtung für einen Audioverstärker.

Zur Erleichterung des Verständnisses der vorliegenden Erfindung sind in der Figur nur die Bestandteile des Audioverstärkers dargestellt, die im Zusammenhang mit der Erfindung von Bedeutung sind.

Das Ausführungsbeispiel nach der Figur weist einen Rundfunkempfänger 2 mit einer Antenne 1, einen an den Rundfunkempfänger 2 angeschlossenen Audioverstärker 3, eine Steuereinrichtung 4, die eine Verbindung mit dem Rundfunkempfänger 2, sowie zwei Verbindungen S und T mit dem Audioverstärker 3 aufweist, auf. An den Audioverstärker 3, der beispielsweise ein Stereo-Audioverstärker sein kann, sind zwei Lautsprecher 5 und 6 angeschlossen. Die Lautsprecher 5 und 6 können auch Lautsprechergruppen 5 und 6 sein. Jede der Lautsprechergruppen 5 und 6 stellt dabei eine Stereo-Lautsprechergruppe dar, weist also Lautsprecher für einen linken und einen rechten Audiokanal auf. Wird das beschriebene Ausführungsbeispiel in einem Fahrzeug eingesetzt, kann die erste Lautsprechergruppe 6 im vorderen Teil des Fahrzeugs angeordnet sein, während die zweite Lautsprechergruppe 5 im hinteren Teil des Fahrzeugs angeordnet ist.

Über die Verbindung zwischen Rundfunkempfänger 2 und Steuereinrichtung 4 wird der Empfangspegel eines vom Rundfunkempfänger 2 empfangenen Rundfunksignals vom Rundfunkempfänger zur Steuereinrichtung 4 übertragen.

Insbesondere bei amplitudenmodulierten Rundfunksignalen ist eine hohe Empfindlichkeit des wiederzugebenden Audiosignals auf Störgeräusche, wie z. B. Zündung oder Lichtmaschine, festzustellen, wenn die Feldstärke des empfangenen Rundfunksignals bestimmte Werte unterschreitet, da dann die Störgeräusche lauter als die eigentliche Nutzmodulation des Rundfunksignals sein können. Deshalb ist in der Steuereinrichtung 4 ein Wert für den Empfangspegel festgelegt, ab dem die Steuereinrichtung 4 die Verstärkungsleistung des Audioverstärkers 3 über die Steuerleitung S reduziert. Dadurch wird eine Reduzierung der Lautstärke des wiedergegebenen Audiosignals erreicht, wodurch die störenden Beeinflussungen weniger wahrgenommen werden. Die Reduzierung der Verstärkungsleistung erfolgt kontinuierlich mit der Abnahme des Empfangspegels. Abweichend kann es auch vorgesehen sein, mehrere Werte für den Empfangspegel in der Steuereinrichtung 4 vorzusehen und jeweils beim Unterschreiten eines der Werte die Verstärkungsleistung des Audioverstärkers 4 stufenweise, z. B. um 15 dB, abzusenken.

Werden zu einem späteren Zeitpunkt erneut höhere Empfangspegel festgestellt, wird die Verstärkungsleistung des Audioverstärkers entsprechend erhöht, bis zum Erreichen des ursprünglich eingestellten Werts.

Zusätzlich kann eine Überwachung der Betriebstemperatur des Audioverstärkers 3 vorgesehen sein. Über die Verbindung T wird der Steuereinrichtung 4 der Wert eines Temperaturfühlers übermittelt, der die Betriebstemperatur insbesondere der Endstufen des Audioverstärkers 3 repräsentiert.

Wird ein in der Steuereinrichtung 4 abgespeicherter Wert für die Betriebstemperatur des Audioverstärkers 3 überschritten, wird die Verstärkungsleistung des Audioverstärkers 3 von der Steuereinrichtung 4 über die Verbindung S verringert. Kühlt der Audioverstärker 3 nach Verringerung der Verstärkungsleistung ab, stellt die Steuereinrichtung 4 wieder die ursprüngliche Verstärkungsleistung ein. Für die Verringerung bzw. anschließende Erhöhung der Verstärkungsleistung kann es vorgesehen sein, die Verstärkungsleistung kontinuierlich mit der Betriebstemperatur oder in Stufen bei Unter- bzw. Überschreiten vorgegebener Werte für die Betriebstemperatur zu verändern.

Um die Wahrnehmbarkeit der Verringerung der Verstärkungsleistung des Audioverstärkers 3 und damit der Lautstärke der von dem Audioverstärker 3 betriebenen Lautsprecher oder Lautsprechergruppen 5 und 6 zu begrenzen, kann die Steuereinrichtung 4 nur die Verstärkungsleistung des Audioverstärkers 3 für einen der Lautsprecher oder eine der Lautsprechergruppen verändern. Dabei wird der Lautsprecher bzw. die Lautsprechergruppe 5 im hinteren Teil des Fahrzeugs bevorzugt.

Die Überwachung der Betriebstemperatur des Audioverstärkers 3 kann auch getrennt von der Überwachung des Empfangspegels oder ohne eine Überwachung des Empfangspegels erfolgen.

## Patentansprüche

1. Steuereinrichtung für einen Audioverstärker, insbesondere eine Steuereinrichtung (4) zur Verringerung störender Beeinflussungen wiederzugebender Audiosignale, wobei die Steuereinrichtung (4) beim Auftreten von störenden Beeinflussungen der wiederzugebenden Audiosignale die Leistung des Audioverstärkers (3) verringert, um die Wiedergabelautstärke der Audiosignale zu reduzieren,
**dadurch gekennzeichnet,**
**dass** die Steuereinrichtung (4) nach Ausbleiben der störenden Beeinflussungen der wiederzugebenden Audiosignale die Leistung des Audioverstärkers (3) auf den vor der Verringerung eingestellten Wert erhöht und die Steuereinrichtung (4) die Leistung des Audioverstärkers (3) stufenweise verringert und/oder erhöht.

2. Audioverstärker nach Anspruch 1,
**dadurch gekennzeichnet,**
**dass** die Steuereinrichtung (4) die stufenweise Veränderung der Lautstärke in Schritten von 15 dB vornimmt.

3. Audioverstärker nach einem der Ansprüche 1 oder 2,
**dadurch gekennzeichnet,**
**dass** bei einem Audioverstärker (3) mit mehreren Gruppen von Endverstärkern (5,6) nur die Leistung einer der Gruppen der Endverstärker (5) verändert wird.

4. Audioverstärker nach einem der Ansprüche 1 bis 3,
**dadurch gekennzeichnet,**
**dass** die Steuereinrichtung (4) wiederzugebende Audiosignale eines Rundfunkempfängers (2) auf das Auftreten von störenden Beeinflussungen untersucht.

5. Audioverstärker nach Anspruch 4,
**dadurch gekennzeichnet,**
**dass** der Rundfunkempfänger (2) für den Empfang amplitudenmodulierter Rundfunksignale ausgelegt ist.

6. Audioverstärker nach Anspruch 4 oder 5,
**dadurch gekennzeichnet,**
**dass** die Steuereinrichtung (4) die Feldstärke des empfangenen Rundfunksignals feststellt und das Unterschreiten eines vorgegebenen Feldstärkewerts als störende Beeinflussung wertet.

7. Audioverstärker nach Anspruch 6,
**dadurch gekennzeichnet,**
**dass** in der Steuereinrichtung (4) mehrere vorgegebene Feldstärkewerte vorgesehen sind und von der Steuereinrichtung (4) überwacht werden.

8. Audioverstärker nach einem der Ansprüche 1 bis 7,
**dadurch gekennzeichnet,**
**dass** die Steuereinrichtung (4) die Betriebstemperatur des Audioverstärkers (4) überwacht, wobei die Überschreitung einer vorgegebenen Temperatur von der Steuereinrichtung (4) als störende Beeinflussung gewertet wird.

9. Audioverstärker nach Anspruch 8,
**dadurch gekennzeichnet,**
**dass** in der Steuereinrichtung (4) mehrere vorgegebene Temperaturen vorgegeben sind und diese von der Steuereinrichtung (4) überwacht werden.

## Claims

1. Control device for an audio amplifier, in particular a control device (4) for reducing interference in audio signals to be reproduced, wherein the control device (4) reduces the output power of the audio amplifier (3) during the occurrence of interference in the audio signals to be reproduced in order to reduce the reproduced sound volume of the audio signals, **characterized in that**, after the disappearance of the interference in the audio signals to be reproduced, the control device (4) increases the output power of the audio amplifier (3) to the value set prior to the reduction and the control device (4) reduces and/or increases the output power of the audio amplifier (3) stepwise.

2. Audio amplifier according to Claim 1, **characterized in that** the control device (4) performs the stepwise alteration of the sound volume in steps of 15 dB.

3. Audio amplifier according to either of Claims 1 or 2, **characterized in that**, in the case of an audio amplifier (3) having a plurality of groups of output amplifiers (5, 6), only the output power of one of the groups of output amplifiers (5) is altered.

4. Audio amplifier according to any one of Claims 1 to 3, **characterized in that** the control device (4) analyses audio signals to be reproduced by a radio receiver (2) for the occurrence of interference.

5. Audio amplifier according to Claim 4, **characterized in that** the radio receiver (2) is designed to receive amplitude-modulated radio signals.

6. Audio amplifier according to Claim 4 or 5, **characterized in that** the control device (4) determines the field strength of the received radio signals and rates the undershooting of a specified field-strength value as interference.

7. Audio amplifier according to Claim 6, **characterized in that** a plurality of specified field-strength values are provided in the control device (4) and are monitored by the control device (4).

8. Audio amplifier according to any one of Claims 1 to 7, **characterized in that** the control device (4) monitors the operating temperature of the audio amplifier (4), the overshooting of a specified temperature being rated by the control device (4) as interference.

9. Audio amplifier according to Claim 8, **characterized in that** a plurality of specified temperatures are specified in the control device (4) and they are monitored by the control device (4).

## Revendications

1. Système de commande pour un amplificateur audio, en particulier un système de commande (4) pour réduire les influences parasites des signaux audio à reproduire, dans lequel le système de commande (4) réduit la puissance de l'amplificateur audio (3) lors de l'apparition d'influences parasites des signaux audio à reproduire, pour réduire l'intensité acoustique de reproduction des signaux audio, **caractérisé en ce que** le système de commande (4) augmente la puissance de l'amplificateur audio (3) à la valeur réglée avant la réduction après l'absence des influences parasites des signaux audio à reproduire et le signal de commande (4) réduit et/ou augmente progressivement la puissance de l'amplificateur audio (3).

2. Amplificateur audio selon la revendication 1, **caractérisé en ce que** le système de commande (4) effectue la modification progressive de l'intensité acoustique par pas de 15 dB.

3. Amplificateur audio selon l'une des revendications 1 ou 2, **caractérisé en ce que**, dans le cas d'un amplificateur audio (3) comportant plusieurs groupes d'amplificateurs terminaux (5, 6), seule la puissance d'un des groupes d'amplificateurs terminaux (5) est modifiée.

4. Amplificateur audio selon l'une des revendications 1 à 3, **caractérisé en ce que** le système de commande (4) examine les signaux audio à reproduire d'un récepteur radio (2) concernant l'apparition d'influences parasites.

5. Amplificateur audio selon la revendication 4, **caractérisé en ce que** le récepteur radio (2) est réglé pour la réception de signaux radio modulés en amplitude.

6. Amplificateur audio selon la revendication 4 ou 5, **caractérisé en ce que** le système de commande (4) définit l'intensité de champ du signal radio reçu et évalue le sous-dépassement d'une valeur d'intensité de champ prédéterminée comme influence parasite.

7. Amplificateur audio selon la revendication 6, **caractérisé en ce que**, dans le système de commande (4), plusieurs valeurs d'intensité de champ prédéterminées sont prévues et sont surveillées par le système de commande (4).

8. Amplificateur audio selon l'une des revendications 1 à 7, **caractérisé en ce que** le système de commande (4) surveille la température de fonctionnement de l'amplificateur audio (4), moyennant quoi le dépassement d'une température prédéterminée est évalué par le système de commande (4) comme influence parasite.

9. Amplificateur audio selon la revendication 8, **caractérisé en ce que**, dans le système de commande (4), plusieurs températures prédéterminées sont prédéfinies et celles-ci sont surveillées par le système de commande (4).
